Europäisches Patentamt

European Patent Office

Office européen des brevets

(11) Veröffentlichungsnummer: **0 371 261**

**A2**

(12) **EUROPÄISCHE PATENTANMELDUNG**

(21) Anmeldenummer: **89119927.5**

(22) Anmeldetag: **26.10.89**

(51) Int. Cl.⁵: **G01V 3/10, H03K 17/00**

(30) Priorität: **01.12.88 DE 3840532**

(43) Veröffentlichungstag der Anmeldung:
**06.06.90 Patentblatt 90/23**

(84) Benannte Vertragsstaaten:
**AT BE CH DE ES FR GB IT LI LU NL SE**

(71) Anmelder: **PEPPERL + FUCHS GMBH**
**Königsberger Allee 87**
**D-6800 Mannheim-Schönau(DE)**

(72) Erfinder: **Helm, Wolfgang, Dipl.-Ing.**
**Alter Weg 52**
**DE-6101 Reichelsheim(DE)**
Erfinder: **Wassner, Josef, Dipl.-Ing.**
**Hintergasse 12**
**DE-6707 Schifferstadt(DE)**
Erfinder: **Craigie, Neil, Dr.**
**Hüttkahlen 38**
**DE-2061 Nahe(DE)**

(74) Vertreter: **Mierswa, Klaus, Dipl.-Ing.**
**Friedrichstrasse 171**
**D-6800 Mannheim 24(DE)**

(54) Verfahren zum induktiven Erzeugen eines elektrischen Messsignals zum Bestimmen des Weges und/oder der Position im Raum und/oder von Materialeigenschaften eines Prüfkörpers und nach diesem Verfahren aufgebauter Näherungssensor und Verwendung desselben als Näherungsschalter.

㋤ Die Erfindung betrifft ein Verfahren zum induktiven Erzeugen eines elektrischen Meßsignals zum Detektieren eineselektrisch leitfähigen Körpers (21) unter Verwendung von wenigstens zwei induktiv gekoppelten Spulen, Treiberspule (2) und Sensorspule (3), von denen die Treiberspule von einem höher frequenten Wechselstrom ($i_T$) durchflossen ist, der in der Sensorspule eine von der zu messenden Größe abhängige Spannung ($U_S$) induziert und wobei ein dem Strom in der Treiberspule proportionales Referenzspannungssignal ($U_{ref}$) erzeugt wird und beide Spannungssignale zum Erhalt des Meßsignals miteinander verknüpft.werden. Aus dem Referenzspannungssignal ($U_{ref}$) und dem Spannungssignal ($U_S$) der Sensorspule wird dasjenige Meßsignal ($U_A$) gewonnen, bei dem durch mathematischschaltungstechnische Verknüpfung Betrag und Phase des Referenzspannungssignals ($U_{ref}$) eliminiert werden und somit dessen Abhängigkeit vom Strom ($i_T$) der Treiberspule aufgehoben wird und nur die Änderung des Betrages ($|U_S|$) und der Phase ($\Phi$) des Spannungssignals ($U_S$) der Sensorspule als Parameter des Meßsignals ($U_A$) verbleiben, das proportional der komplexen Leistung ($P_T$) im Magnetfeld der Treiberspule ist, wobei die komplexe Leistung ($P_S$) innerhalb des Sensorkreises konstant -vorzugsweise praktisch vernachlässig- bar klein- gehalten wird und das Spannungssignal ($U_S$) der Sensorspule (3) eine maximale Empfindlichkeit zum Meßgegenstand (21,36,44) hat im Gegensatz zum Referenzspannungssignal ($U_{ref}$), das eine minimale Empfindlichkeit zum Meßgegenstand besitzt.

Fig. 2

## Verfahren zum induktiven Erzeugen eines elektrischen Meßsignals zum Bestimmen des Weges und/oder der Position im Raum und/oder von Materialeigenschaften eines Prüfkörpers und nach diesem Verfahren aufgebauter Näherungssensor und Verwendung desselben als Näherungsschalter

Die Erfindung betrifft ein Verfahren zum induktiven Erzeugen eines elektrischen Meßsignals zum Bestimmen des Weges und/oder der Position im Raum und/oder von Materialeigenschaften eines Prüfkörpers gemäß dem Oberbegriff des Patentanspruchs 1 und einen nach diesem Verfahren aufgebauten Näherungsschalter.

Es sind induktive Näherungsschalter auf der Basis der Wirbelstromverluste bekannt, die in einem sich dem Näherungssensor nähernden metallischen Gegenstand verursacht werden. Dabei wird die Änderung der Güte eines LC-Oszillator-Schwingkreises mit einer entsprechenden elektrischen Schaltung ausgewertet. Der Hauptnachteil dieses Prinzips ist, daß der Näherungssensor auch den Wirbelstromverlust in der Umgebung erfaßt, z.B. innerhalb eines Metallgehäuses oder einer Metallwand, in die der Sensor eingebaut ist. Dies hat vor allem einen verschlechternden Effekt auf den Schaltabstand des Näherungssensors und verursacht somit einen entsprechend großen Reduktionsfaktor, ermittelt über den Nennschaltabstand $s_n$ mit einer Meßfahne aus Stahl St37, für paramagnetische Metalle, wie Aluminium, oder für diamagnetische Metalle wie Kupfer. Bei einem Näherungssensor mit Abschirmungsring und Stahlgehäuse ändert sich die Güte bei diesen Materialien zunächst nicht, bzw. steigt etwas an und nimmt erst bei kleinem Abstand auf den Wert des Schaltpunktes ab. Der Grund hierfür ist ein Kompensationseffekt zwischen dem Wirbelstrom, erzeugt im para- oder diamagnetischen Gegenstand und dem Wirbelstrom, der im Stahlgehäuse bzw. Abschirmungsring induziert wird. Die Stromänderung im Gegenstand ist bei großem Abstand sohon bedeutend, wirkt sich aber wegen des Kompensationseffektes nicht als Reduzierung der Güte des Schwingkreises aus und kann deshalb zur Messung nicht genau genug herangezogen werden.

Durch die DE-A1-30 14 416 ist ein Näherungsschalter mit einer Hochfrequenz-Schwingungsschaltung für kompakte Näherungsschalter bekanntgeworden, bei dem eine Spule einen Kern aufweist, der auf seiner Rückfläche einen mit einer Nachweisspule verbundenen Kondensator trägt, der Teil eines Resonanzkreises einer Schwingungsschaltung ist. Resonanzkondensator und Nachweisspule sollen derart nahe aneinander aufgebaut sein, daß der Widerstand des den Resonanzkreis mit der Schwingungsschaltung verbindenden Kabels vernachlässigbar ist.

Durch die EP-0070796 ist ein Verfahren zur Kompensation der Temperaturabhängigkeit der Schwingamplitude eines durch einen Generator angeregten Schwingkreises bekanntgeworden, bei dem die Temperaturabhängigkeit des spezifischen Widerstandes des Leitermaterials der Schwingkreisspule dazu benutzt wird, die Amplitude des durch den Generator erzeugten Signales proportional zum temperaturabhängigen Widerstand des Leitermaterials der Schwingkreisspule zu steuern. Ein nach diesem Verfahren aufgebauter Oszillator ist schaltungstechnisch schwierig zu realisieren und störanfällig. Dazu ist eine dynamische Kompensation notwendig, die den Nachteil hat, daß der Reduktionsfaktor ungenügend wird und der Schaltabstand beträchtlich zurückgeht. Ein weiterer Nachteil eines derartigen Schalters besteht darin, daß dieser nicht bündig einbaubar ist.

Durch die DE-A1-3326476 ist ein Sensor nach dem Differentialtransformator-Prinzip bekannt geworden zur Bestimmung der Position, der geometrischen Abmessungen oder der Bewegungsgrößen eines metallischen Gegenstandes mit unterschiedlich lokalisierten Magnetfeld-Sensoren im Einflußbereich des magnetischen Wechselfeldes, deren Ausgangssignale eine durch den zu bestimmenden Gegenstand bewirkte Beeinflussung des magnetischen Wechselfeldes erkennen lassen. Zur Auswertung der Signale der Magnetfeld-Sensoren sind mindestens zwei Magnetfeld-Spulensensoren vorgesehen, zwischen deren Signalen die Differenz in einer phasenempfindlichen Gleichrichterschaltung gebildet wird. Wesentlich ist, daß die beiden Spulen symmetrisch positioniert sind, wobei ohne einen sich nähernden Gegenstand das Meßsignal Null ist.

In der DE-3814131 ist ein induktiver Näherungsschalter mit einer Wirkleistungsmessung der magnetischen Verluste vorgeschlagen worden. Statt der Auswertung des Resonanzwiderstandes eines Schwingkreises wird hier direkt die Verlustleistung im Magnetfeld mittels einer Vierleitermessung von Spulenspannung und Spulenstrom gemessen. Dabei sollen weder der Zuleitungs- noch der Wicklungswiderstand in die Messung eingehen. In Abhängigkeit davon, ob der Wirk- oder der Blindanteil der Feldverlustleistung ausgewertet wird, ist die Messung entweder von der elektrischen oder magnetischen Leitfähigkeit des zu detektierenden Materials abhängig. Die Leistungsmessung erfolgt durch Multiplikation von Strom und Spannung phasenrichtig miteinander, um dadurch den von der Induktivität unabhängigen Wirkanteil zu bestimmen. Dadurch ist es in nachteiliger Weise notwendig, einen hochkonstanten Strom in der Treiberspule aufrecht zu erhalten. Die Realisierung der Multiplikatorschaltung soll dadurch geschehen, daß über einen Spannungsteiler eines ohmschen Widerstandes mit der Treiberspule eine über den ohmschen Widerstand abfallende, dem Primärspulenstrom proportionale Differenzspannung gewonnen wird, die nach Verstärkung auf den ersten Eingang eines Analogmultiplizierers gegeben wird, dessen zweiter Eingang an der ebenfalls verstärkten Spannung der Sekundärspule liegt. Nach Integration des so erhaltenen Produkts durch einen Tiefpaß soll das Ausgangssignal dem Wirkanteil der Verlustleistung im Magnetfeld proportional sein. Das ist allerdings nur der Fall, wenn der Strom in der Treiberspule hochkonstant gehalten wird, was schaltungstechnisch auf erhebliche Schwierigkeiten stößt. Über den Primärspulenstrom soll die hohe Temperaturabhängigkeit der Meßanordnung erhalten bleiben, zu deren Kompensation erhebliche schaltungstechnische Aufwendungen notwendig wären.

Der Erfindung liegt die Aufgabe zugrunde, das Verfahren der eingangs genannten Gattung derart zu verbessern, daß es zum einen von einem sich ändernden Strom in der Treiberspule und von Temperaturänderungen unabhängig ist, zum anderen soll es eine hohe Richtwirkung zeigen und die Umgebung, in die der Näherungssensor eingebaut ist, ohne Einfluß auf die Meßgenauigkeit des Verfahren bleiben; insbesondere soll ein nach dem Verfahren arbeitender Näherungssensor eine um ein Mehrfaches erhöhte Empfindlichkeit, einen großen Schaltabstand und keinen Reduktionsfaktor für paramagnetische Metalle aufweisen.

Die Lösung der Aufgabe besteht erfindungsgemäß in den Merkmalen des Anspruchs 1. Ein induktiver Näherungsschalter nach der Erfindung ist in Anspruch 5, ein Positionssensor in Anspruch 12 gekennzeichnet.

Das erfindungsgemäße Verfahren besitzt den hervorstechenden Vorteil, daß dieses unter Vermeidung der üblichen Auswertung des Resonanzwiderstandes eines Schwingkreises direkt die komplexe Verlustleistung im Magnetfeld der Treiberspule oder die Induktivität derselben zu bestimmen gestattet, jedoch in vorteilhafter Weise unabhängig von dem sich ändernden Strom in der Treiberspule und damit unabhängig von Temperaturänderungen des Treiberspulenkreises. Das hat die Vorteile, daß der Strom in der Treiberspule nicht konstant zu sein braucht, weshalb für den Aufbau und die Realisierung der Schaltung hinsichtlich des Treiberspulenkreises ein einfacher Schaltungsaufbau verwendet werden kann. Dadurch ist das Verfahren praktisch temperaturunabhängig, so daß die erfindungsgemäße Meßschaltung auf schaltungstechnische Kunstgriffe hinsichtlich einer Temperaturstabilisierung verzichten kann.

Ein weiterer Vorteil des erfindungsgemäßen Verfahrens ist darin begründet, daß die Schaltfrequenz erheblich höher liegt, als bei der Wirbelstromverlustmessung. Es lassen sich leicht Schaltfrequenzen von über 4 kHz erreichen.

Denn in vorteilhafter Weise wird beim erfindungsgemäßen Verfahren die Abhängigkeit der Referenzspannung vom Erregerstrom in der Treiberspule mathematisch-schaltungstechnisch eliminiert. Das zieht den weiteren Vorteil nach sich, daß der Eingangswiderstand der an der Sekundär- oder Sensorspule anliegenden Meßschaltung um einige Zehnerpotenzen größer ist, als der gesamte Ersatzwiderstand des Transformators. Dadurch sind die gemessenen Meßsignale nach der Sensorspule praktisch unbelastet und damit unverfälscht, z.B. durch eine Tempe raturdrift. Die Leistung innerhalb des Sensorkreises muß konstant sein, was am einfachsten dadurch erhalten wird, daß die Sensorspannung praktisch verlustfrei hochohmig weiterverarbeitet wird.

Die Änderung der Sensorspannung bezogen auf dieselbe folgt der Gleichung:

$$\frac{\Delta U_s}{U_s} = \frac{M_{23} \, M_{13}}{M_{12} \, Z_3 / \omega}$$

wobei $M_{12}$ die gegenseitige Induktivität zwischen Treiberspule und Sensorspule, $M_{13}$ die gegenseitige Induktivität zwischen Treiberspule und sich nähernden Gegenstand, $M_{23}$ die gegenseitige Induktivität zwischen Sensorspule und sich nähernden Gegenstand, die komplexe Impedanz $Z_3$ und $\omega$ die Frequenz des Treiberspulenstromes $i_T$ bedeuten.

Daraus ist ersichtlich, daß diese Größe $\Delta U_s / U_s$ fast temperaturunabhängig ist und sich der einzige Temperatureffekt aus der Temperaturänderung des sich nähernden Gegenstandes ergibt, was bei hoher Frequenz praktisch keine Rolle spielt. Das führt dazu, daß der gesamte Näherungssensor praktisch frei von Temperaturdrift ist, so daß Schaltschwellen von $\Delta U_s / U_s$ um die 1%-Ebene möglich sind.

Die Gewinnung und Auswertung des Meßsignals geschieht in schaltungstechnischer Verknüpfung entweder über die in der Sensorspule induzierte Spannung, die wegen der Hochohmigkeit der Meßschaltung (Leistung im Sensorkreis praktisch Null) die Erfassung von sehr kleinen Änderungen ermöglicht, oder über die Phasenverschiebung zwischen Primärspulenstrom und Spannung der Sensorspule, wobei sowohl die Änderung der induzierten Spannung als auch die Änderung der Phase proportional der Verlustleistung des Treiberkreises sind.

Ein nach dem erfindungsgemäßen Verfahren arbeitender Näherungsschalter besitzt in vorteilhafter Weise einen um ein Mehrfaches höheren Schaltabstand als Näherungsschalter des Standes der Technik auf der Basis der Wirbelstromverlustmessung. Einer der Gründe dafür ist, daß bei der Wirbelstromverlustmessung die Empfindlichkeitsänderung bei einer Abstandsänderung des Abstandes d mit $d^{-4}$ abfällt, wohingegen die Änderung der induzierten Spannung in der Sensorspule für höhere Abstände nur mit $d^{-3}$ abfällt. Beispielsweise wird für Aluminium für höhere Abstände, z.B. d > 20 mm für einen Kerndurchmesser von 16 mm, beim erfindungsgemäßen Verfahren ein ausgeprägtes Signal erhalten, hingegen nicht mehr bei der Wirbelstromverlustmessung des Standes der Technik.

Ein weiterer Vorteil des erfindungsgemäßen Verfahrens besteht darin, daß dieses praktisch keinen Reduktionsfaktor für nichtferromagnetische, also für dia- und paramagnetische, Metalle besitzt. Wegen einer ausgeprägten σ-μ-Kennlinie (elektrische Leitfähigkeit aufgetragen über der Permeabilität) ergibt sich daraus der Vorteil, daß mittels des Verfahrens dia- und paramagnetische Metalle untereinander und auch von ferromagnetischen Metallen unterschieden werden können.

Des weiteren gestattet das erfindungsgemäße Verfahren den Bau eines vorteilhaften Näherungsschalters in Standardgehäuse, der bei hoher Reichweite eine sehr niedrige seitliche Empfindlichkeit besitzt und somit bündig in Metallwände eingebaut werden kann.

Ein weiterer Vorteil des erfindungsgemäßen Verfahrens besteht darin, daß damit induktive Mehrspulennäherungssensoren auf der Basis von zwei oder mehr Sensorspulen aufgebaut werden können, mit denen zum Beispiel die Position eines Objektes in der X-Z-Ebene oder auch die Rotation eines mechanischen Bauteils oder beides zugleich überwacht werden kann.

Beispiele der Erfindung sind in der Zeichnung dargestellt und anschließend beschrieben. Dabei zeigen:

Figur 1 ein prinzipielles Blockschaltbild einer Grundschaltung zur Erläuterung des Funktionsprinzips des erfindungsgemäßen Verfahrens

Figur 2 ein Blockschaltbild mit einem Dividierer zur Kompensation von Betrag und Frequenz eines nichtkonstanten Treiberstromes

Figur 3 ein prinzipielles Blockschaltbild einer weiteren Grundschaltung mit durch das Referenzsignal stabilisierter Stromquelle des Treiberstomes

Figur 4 ein prinzipielles Blockschaltbild eines Näherungssschalters mit einem Frequenz-Spannungswandler zur Frequenzkompensation bzw. Nachregelung der Referenzspannung über die Frequenz des Treiberstromes

Figur 5 ein Blockschaltbild mit einer Treiberspule und zwei Sensorspulen, deren eine eine Referenzspule ist, zur induktiv-abgeleiteten Erzeugung der Referenzspannung

Figur 6 einen Mehrspulensensor mit einer Mehrzahl von Treiberspulen und Sensorspulen

Figur 7 ein Blockschaltbild des Mehrspulensensors nach Figur 6

Figur 8 ein Ausführungsbeispiel eines Näherungssensors gemäß den Figuren 6 und 7, zum Beispiel zum Einsatz für ein Ventil

Figur 9 eine Anordnung für den bündigen Einbau eines Mehrspulensensors, hier eines Dreispulensensors, in eine Metallwand, als Näherungsschalter

Figur 10 ein Blockschaltbild eines Näherungssensors, bei dem das Meßsignal über Erfassung von Betrag und Phase der Sensorspannung gewonnen wird mittels eines Allpassfilters mit einstellbarer Phasenverschiebung

Figur 11 ein Blockschaltbild eines Näherungssensors mit einer Regelschleife, mit der die Phasenverschiebung θ schrittweise verändert werden kann

Figur 12 ein Blockschaltbild eines Multiplizier- und Addierteils zur Erzeugung einer zum Abstand des Prüfkörpers linearen Ausgangsspannung und

Figur 13 eine Analogschaltung zur Erzeugung einer zum Abstand des Prüfkörpers linearen Ausgangsspannung $U_A$ bei Abständen für d>10 mm

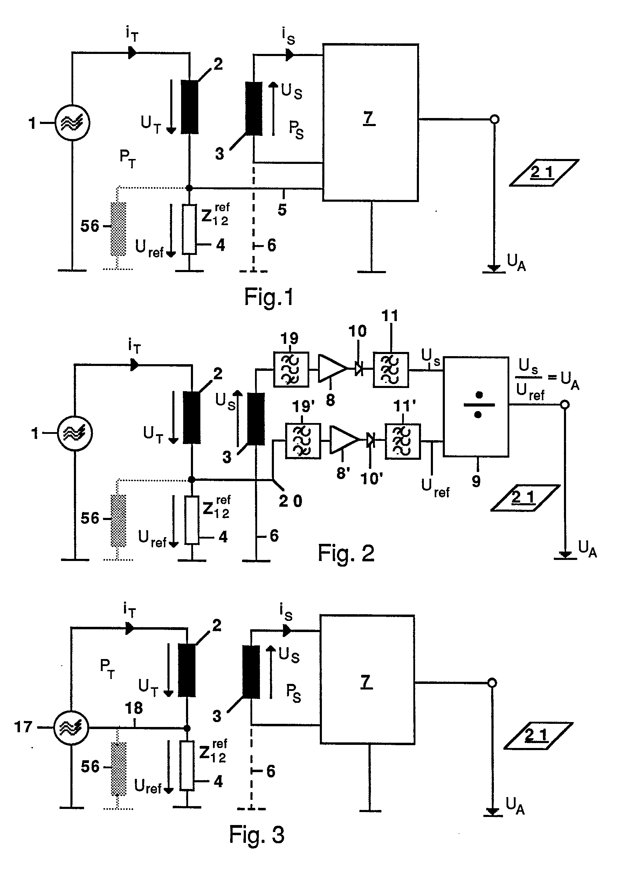

Figur 1 zeigt ein prinzipielles Blockschaltbild eines Näherungssensors zur Verwirklichung des erfindungsgemäßen Verfahrens, bestehend aus einem Stromgenerator 1, der mit seinem Strom $i_T$ eine Treiberspule 2 speist, die in einer induktiv gekoppelten Sensorspule 3 als Sekundärspule nach dem Induktionsgesetz eine Spannung $U_S$ induziert. Die Sensorspule 3 dient als Signalempfänger.

Gleichzeitig wird aus dem Treiberkreis eine Referenzspannung $U_{ref}$ gewonnen, z.B. über einen Spannungsteiler, gebildet aus Treiberspule 2 und komplexem Referenzschaltkreis 4, der ein komplexer Widerstand 4 sein kann, zum Beispiel eine Gegeninduktivität $Z_{ref12}$. Diese Referenzspannung $U_{ref}$ hängt am Ort ihrer Entstehung in Betrag und Phase vom Treiberspulenstrom $i_T$ ab. Über eine Leitung 5 wird diese Referenzspannung $U_{ref}$ und gleichzeitig die Sensorspulenspannung $U_S$ auf einen elektrischen Baustein 7 gegeben, der u.a. eine mathematischschaltungstechnische Verknüpfung dergestalt durchführt, daß Betrag und Phase der Referenzspannung $U_{ref}$ eliminiert werden und somit deren Abhängigkeit vom Strom $i_T$ der Treiberspule 2 aufgehoben wird, so daß nur der Betrag $|U_S|$ und die Phase $\Phi$ des Spannungssignals $U_S$, bzw. die Änderungen $\Delta$ des Betrages $|U_S|$ und der Phase $\Phi$,

der Sensorspule 3 als Parameter des Meßsignals $U_A$ am Ausgang des Bausteins 7 verbleiben, welches proportional der induktiven Kopplung ($Z_{12}$) zwischen Treiberspule 2 und Sensorspule 3 ist. Es ist möglich, die induktive Kopplung proportional auf die komplexe Leistung $P_T$ im Magnetfeld der Treiberspule 2 einfach umzurechnen.

Mit einer gestrichelten Leitung 6 von der Sensorspule 3 zur Masse ist prinzipiell angedeutet, daß die Sensorspule 3 auch direkt auf Masse gelegt sein kann. Damit das Ausgangssignal $U_A$ eine zur komplexen Leistung $P_T$ im Magnetfeld der Treiberspule 2 bzw. zur Gegeninduktivität zwischen dem Treiberkreis und dem Sensorkreis proportionale Größe ist, ist es notwendig, daß die Leistung $P_S$ im Sensorkreis konstant ist. Dann ist die Änderung des Ausgangssignals $U_A$ der sich ändernden Leistung $P_T$ bzw. der sich ändernden Gegeninduktivität zwischen dem Treiberkreis und dem Sensorkreis bei Beeinflussung durch einen Prüfkörper 21 proportional, wobei eine Beeinflussung des Referenzsignals durch den Prüfkörper 21 praktisch nicht vorhanden ist.

Diese Konstanz der komplexen Leistung $P_S$ ($P_S$ = konstant) des Sensorkreises wird am einfachsten dadurch erreicht, indem das Spannungssignal $U_S$ praktisch unbelastet verarbeitet wird, so daß in bezug auf die Leistung $P_T$ im Treiberkreis die Leistung $P_S$ im Sensorkreis um einige Zehnerpotenzen geringer und somit vernachlässigbar ist; diese Ausgestaltung zeigt Figur 2; diese Ausgestaltung mit $P_S \approx 0$ betreffend den Sensorkreis liegt auch sämtlichen folgenden Figuren zugrunde.

Figur 2 zeigt ein Blockschaltbild nach Figur 1 zur Durchführung des Verfahrens mit $P_S \approx 0$, wobei hier die Sensorspule 3 über die Leitung 6 auf Masse gelegt ist und die induzierte Sensorspulenspannung $U_S$ -vorzugsweise nach Passieren eines Bandfilters 19- in einem Meßverstärker 8 praktisch verlustlos verstärkt, anschließend in einem Gleichrichter 10 gleichgerichtet, über ein Tiefpassfilter gefiltert und einem Dividierer 9 zugeführt wird. Die aus dem komplexen Referenzschaltkreis 4 gewonnene Referenzspannung $U_{ref}$ wird über eine Leitung 20 ebenfalls dem Dividierer 9 aufgegeben, wobei bevorzugt die Referenzspannung $U_{ref}$ ebenfalls über ein Bandfilter $19'$, einen Verstärker $8'$, einen Gleichrichter $10'$ und ein Tiefpaßfilter $11'$ gelegt ist. Die Meßgröße $U_A$ wird innerhalb des Dividiers 9 gebildet aus dem Quotienten der verstärkten, und vorzugsweise gefilterten, Sensorspulenspannung $U_S$ und der Referenzspannung $U_{ref}$ gemäß: $U_A = U_S/U_{ref}$.

Ein wesentlicher Vorteil dieser Schaltung ist der, daß damit der Eingangsstrom $i_S$ des Meßverstärkers 8 fast Null ist, da dieser eine sehr hohe Eingangsimpedanz hat und damit die Spannung $U_S$ der Sensorspule 3 im Leerlauf mißt. Das bedeutet, daß in einem derartigen System praktisch keine Temperaturdrift vorhanden ist.

Ein weiterer Vorteil dieser Schaltung besteht darin, daß dadurch die Frequenzabhängigkeit entfällt und am Ausgang ein sehr stabiles Meßsignal $U_A$ erzeugt wird. Bei Gleichrichtung der verstärkten Sensorspulenspannung $U_S$ wird so eine Gleichspannung gewonnen, die zur Bildung eines Näherungssensors mit einer, vorteilhafterweise konstanten, Referenz- bzw. Triggerspannung verglichen wird.

Es ist auch möglich, die Meßgröße $U_A$ aus der Differenz der Sensorspulenspannung $U_S$ und der Referenzspannung $U_{ref}$ zu bilden gemäß: $U_A = U_S - U_{ref}$.

Allgemein wird zum Beispiel die Referenzspannung $U_{ref}$ aus $i_T$ dadurch gewonnen, indem die Treiberspule 2 und der komplexe Referenzschaltkreis 4, der ein komplexer Widerstand $Z_{ref12}$ sein kann - in Reihe geschaltet sind und die Referenzspannung $U_{ref}$ von dem so erhaltenen Spannungsteiler abgegriffen wird. Die Gegeninduktivität $Z_{ref12}$ muß dabei proportional zu $M_{12}$ sein, das heißt proportional der Kopplung zwischen Treiber- und Sensorspule bzw. einer Referenzspule ohne Prüfkörper 21. Diese Kopplung $\omega M_{12}$ kann z.B. durch eine zweite Sensorspule -das ist die Referenzspule- bzw. dritte Spule -und weitere Spulen- realisiert werden, die direkt mit der Treiberspule gewickelt und entsprechend dimensioniert sind. In diesem Fall ist $Z_{ref12} = \omega M_{ref12}$ und somit ebenfalls eine Gegeninduktivität. Wenn diese dritte Spule -und weitere Spulen- beispielsweise innerhalb eines Ferritkerns eines Näherungssensors angeordnet ist, ist ihre Kopplung zur Treiberspule hoch und die Beeinflussung durch einen sich nähernden Prüfkörper 21 praktisch vernachlässigbar. Ein derartiges System mit wenigstens einer Referenz- oder Kompensationsspule verbessert die Temperaturstabilität und bietet eine zusätzliche Störkompensation.

Figur 3 zeigt ein prinzipielles Blockschaltbild einer weiteren Grundschaltung mit einem durch das Referenzsignal stabilisierten Stromgenerator 17 des Treiber stromes $i_T$, wobei diese Schaltung ansonsten der Schaltung der Figur 1 entspricht. Die mittels des komplexen Referenzschaltkreis 4, der ein komplexer Widerstand 4 sein kann, zum Beispiel eine gegenseitige Induktivität $Z_{ref12}$, gewonnene Referenzspannung $U_{ref}$ dient über eine Leitung 18 zur Stabilisierung des Stromgenerators 17, um einen hochkonstanten Treiberstrom $i_T$ zu erzeugen, der bei Konstanz eine konstante Leistung $P_S$ innerhalb des Sensorkreises zur Folge hat.

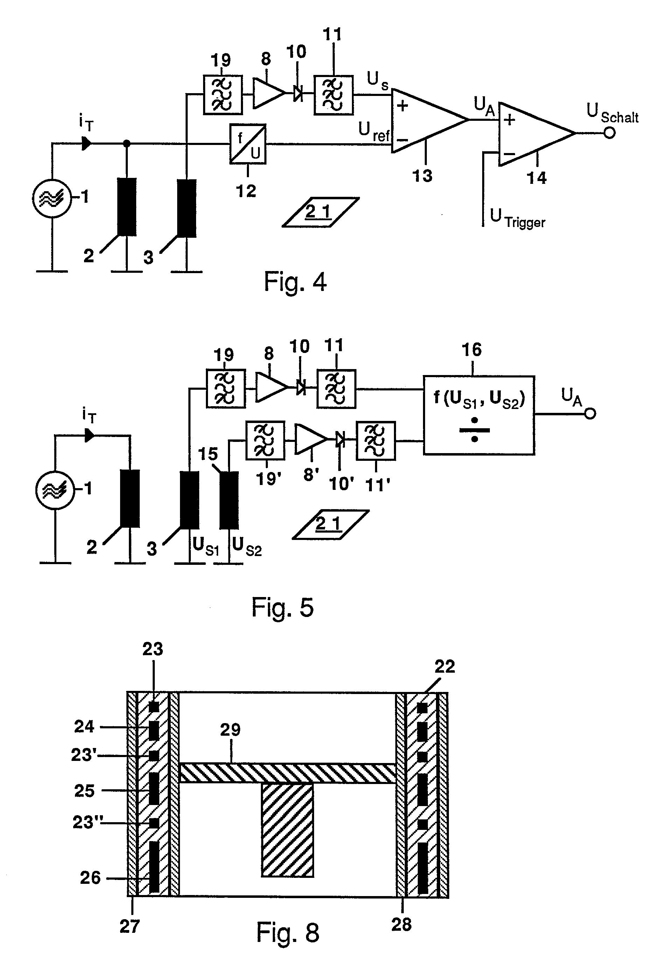

Ein weiteres Beispiel eines erfindungsgemäßen Näherungssensors, der als Näherungsschalter arbeitet, ist im Blockschaltbild der Figur 4 dargestellt. Die Referenzspannung $U_{ref}$ wird direkt aus der Treiberspannung $U_T$ der Treiberspule 2 abgeleitet und über einen Frequenz-Spannungswandler 12 dem einen Eingang (-) eines Komparators 13 bzw. Dividierers zugeführt. Gleichzeitig wird die Sensorspulenspannung $U_S$ nach Passieren eines Bandpasses 19 in einem Meßverstärker 8 verstärkt, in einem Gleichrichter 10 gleichgerichtet und auf ein Tiefpassfilter 11 gegeben, dessen Ausgangssignal $U_S$ dem anderen Eingang (+) des Komparators 13 bzw. Dividierers zugeführt wird, dessen Ausgangssignal das Meßsignal $U_A$ darstellt, welches zum Erhalt eines Näherungsschalters z.B. auf den einen Eingang (+) eines weiteren Komparators 14 gelegt wird, an dessen anderen Eingang (-) eine Schwellwert- oder Triggerspannung $U_{Trigger}$ gelegt ist und so durch den Spannungsvergleich ein Schaltsignal $U_{Schalt}$ ausgelöst werden kann.

Ist die Amplitude von $i_T$ innerhalb von 1 % konstant und läßt man eine Frequenzdrift zwischen 3-5 % zu, so muß die Referenzspannung $U_{ref}$ nachgeregelt werden, um den Effekt der Drift zu beseitigen. Da das Ausgangssignal $U_A$ direkt proportional zur Amplitude und Frequenz f von $i_T$ ist, kann die Schaltung der Figur 4 in einfacher Weise mittels des Frequenz-Spannungswandlers 12 realisiert werden. Figur 5 zeigt das prinzipielle Blockschaltbild eines Näherungssensors mit einer Treiberspule 2 und zwei Sensorspulen 3, 15 zum Aufbau eines induktiven Mehr spulensensors, wobei die zweite Sensorspule eine Referenzspannungsspule 15 zur Bildung der Referenzspannung $U_{ref}$ ist. Die Treiberspule 2 speist zwei Sensorspulen 3,15, deren induzierte Spannungen $U_{S1}$ und $U_{S2}$, vorzugsweise nach Passieren je eines Bandfilters 19, 19', über je einen Meßverstärker 8, 8' auf einen Komparator 16, oder Dividierer, gegeben werden. Durch das Verhältnis der Spannungen $U_{S1}$ und $U_{S2}$ (usw.) zueinander wird eine Auskunft über die Position eines sich nähernden metallischen Prüfkörpers erhalten.

Allgemein erfolgt die Ableitung des Referenzspannungssignal $U_{ref}$ aus einem komplexen Referenzschaltkreis, der vorzugsweise eine Referenzspule 15 beinhaltet und somit die Gegeninduktivität $Z_{ref12}$ zwischen Treiberspule 2 und Referenzspule 15 zur Gewinnung des Referenzspannungssignal $U_{ref}$ dient.

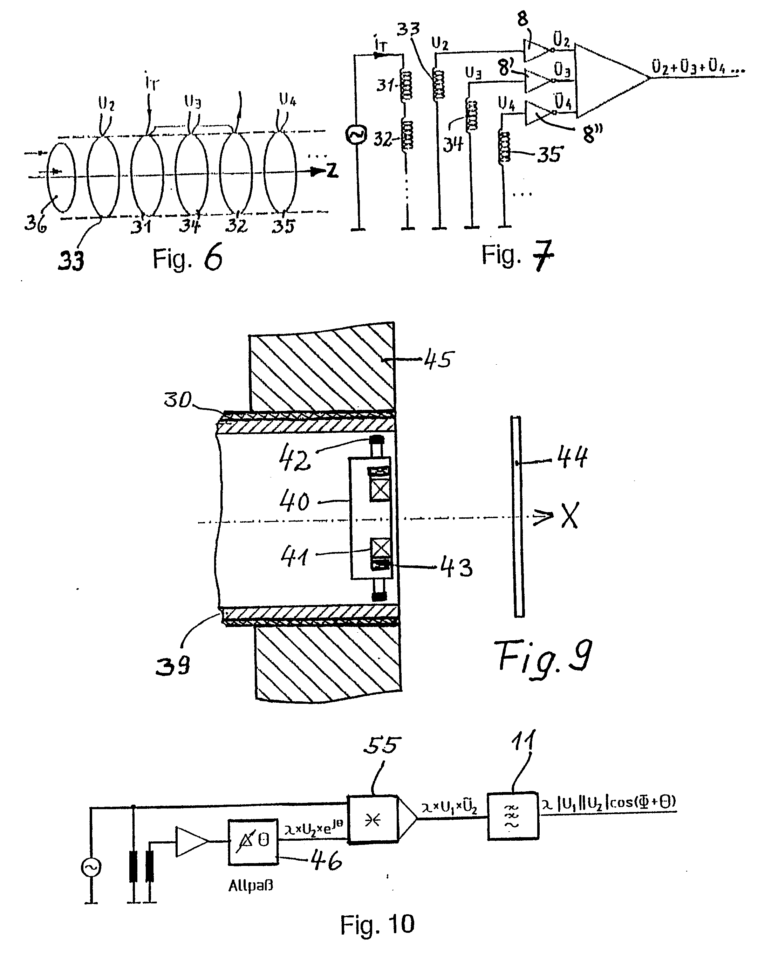

Figur 6 zeigt einen Mehrspulensensor mit einer Mehrzahl von Treiber- und Sensorspulen, z.B. zur Messung eines metallischen Prüfkörpers in Form eines Ringes oder einer Scheibe innerhalb eines Rohres. Vorzugsweise sind innerhalb eines Rohrmantels abwechselnd Treiberspulen 31, 32,... angeordnet, die vorzugsweise in Reihe geschaltet sind. Dazwischen sind jeweils Sensorspulen bzw. Referenzspulen 33, 34, 35 - vorzugsweise parallel zueinander - angeordnet, denen ein Prüfkörper 36 gegenübersteht. Die Treiberspulen sind von den Sensorspulen bzw. Referenzspulen galvanisch getrennt. Vorzugsweise sind auch die Sensorspulen untereinander und von den Referenzspulen galvanisch getrennt.

Beispielsweise besitzt die Sensorspule 33 die Anzahl von $n_0$ Windungen, die Sensorspule 34 besitzt $2n_0$ Windungen, die Sensorspule 35 besitzt $3n_0$ Windungen usw. Dies bewirkt induzierte Spannung $U_{S2} = U_0$, $U_{S3} = 2U_0$, $U_{S4} = 3U_0$ usw. Ein im Prüfkörper 36 induzierter elektrischer Stromkreis verringert die eine oder die andere dieser Spannungen, wodurch die Stellung eines Prüfkörpers detektiert werden kann.

Figur 7 zeigt ein prinzipielles Blockschaltbild des Mehrspulensensors nach Figur 6. Jede Sensorspule 33, 34, 35 ist über einen Meßverstärker 8, 8', 8'' und gegebenenfalls weitere Beschaltung auf einen Komparator 37, z.B. ein Addierer oder Dividierer, gelegt. In jeder Spule wird die Summe der komplementären Spannungen, bezogen auf die gegebene Spannung $U_0$, ausgewertet. Das heißt, wenn der Prüfkörper 36 (Figur 6) an einer gegebenen Spule n vorbeigeführt wird, ergibt sich für diese Spulenspannung $U_n \longrightarrow 0$, so daß die Summe der Spannungen $\Sigma U = U_{S2} + U_{S3} + U_{S4} \ldots \longrightarrow nU_0$ wird. Somit erhöht sich die Spannung je nach der Position des Prüflings 36 stufenweise.

Figur 8 zeigt ein Ausführungsbeispiel eines Mehrspulensensors gemäß der Figuren 6 und 7 beispielsweise für ein Ventil. Innerhalb eines z.B. hohlzylindrischen Körpers 22, der aus elektrisch nichtleitendem, jedoch magnetisch leitendem Material besteht, sind übereinander z.B. vier Spulen 23, 24, 25, 26 angeordnet, von denen z.B. die Spule 23 die Treiberspule 23 ist, die in eine Mehrheit von in Reihe geschalteten einzelne Spulen 23, 23', 23'' zwischen den drei Sensorspulen 24, 25, 26 bzw. Referenzspulen aufgeteilt ist, wobei alle Spulen innerhalb des Körpers 22 torusförmig eingebettet sind. Die Sensorspule 24 hat die Zahl von $n_0$ Windungen, die Sensorspule 25 besitzt $2n_0$ Windungen, die Sensorspule 26 besitzt $3n_0$ Windungen. Ein metallischer Prüfkörper 29 ist als kreisförmige, bewegliche Scheibe innerhalb des Körpers 22 ausgebildet, der beispielsweise in einem Rohr 27 aus Ferritmaterial angeordnet sein kann. Innerhalb des Körpers 22 kann eine Führungshülse 28 angeordnet sein. Gemäß den Erläuterungen zu den Figuren 6 und 7 kann dergestalt die Stellung des Prüfkörpers 29 innerhalb des Körpers 22 detektiert werden.

Die beschriebenen Anordnungen nach den Figuren 6, 7 und 8 können auch für die Überwachung der Rotation eines mechanischen, rotierenden Bauteils eingesetzt werden, wenn eine oder mehrere Sensor- oder Referenzspulen zu wenigstens einer Treiberspule beweglich, beispielsweise drehbar, auf einem sich bewegenden Körper angeordnet sind. Die Achsen der Spulen können dabei zusammenfallen, so daß lediglich der Drehwinkel zwischen den Spulen variiert. Dann ergibt sich die Spannung in der oder den Sensor- bzw. Referenzspulen als Funktion des Drehwinkels.

Figur 9 zeigt eine Anordnung für den bündigen Einbau eines Näherungssensor 38 mit beispielsweise drei Spulen innerhalb einer Metallwand. Der Näherungssensor 38, der innerhalb eines Sensorgehäuses 39, beispielsweise ein Stahlzylinder, angeordnet ist, besteht aus einem Kern 40, innerhalb desselben eine torusförmige Treiberspule 41 angeordnet ist. Um diese Treiberspule 41 ist in der gleichen Ebene eine Referenzspule 43 gelegt. Eine Sensorspule 42 umfaßt torusförmig die Treiberspule 41 und die Referenzspule 43, wobei die Sensorspule 42 nahe des Sensorgehäuses 39 verläuft. Das Sensorgehäuse 39 ist vorzugsweise in einer magnetischen Abschirmhülse 30, z. B. aus Ferritmaterial, angeordnet. Diese Ausgestaltung ist mit dem Sensorgehäuse 39 und der Abschirmhülse 30 bündig in eine Metallwand 45 eingebaut. Ein sich nähernder metallischer Prüfkörper 44 zeigt einen hohen Schaltabstand senkrecht zur Stirnfläche des Näherungssensors 38, jedoch eine geringe seitliche Empfindlichkeit. Die Meßgröße wird gebildet aus dem Quotienten (oder aus der Differenz) der induzierten Spannung $U_{S2}$ innerhalb der Sensorspule 42 und der Referenzspannung $U_{ref}$ innerhalb der Referenzspule 43. Diese Meßgröße ist praktisch temperaturunabhängig und hängt nur vom Durchmesser der Sensorspule 42 und der Einbautiefe der Sensorspule 42 in bezug auf die Einbauebene der Treiberspule 41 ab.

In vorteilhafter Weise können Treiberspule und Sensorspulen auch vertauscht werden, so daß die Spule 42 die Treiberspule und die Spulen 40, 43 die Sensorspulen sind. Mit dieser Anordnung wird eine ausgezeichnete Richtwirkung erzielt.

Figur 10 zeigt einen Näherungssensor zum Erfassen des Betrages und der Phase der Sensorspannung mittels eines Allpaß-Filters 46, mit dem eine einstellbare Phasenverschiebung erzielbar ist. In diesem Fall wird die Treiberspulenspannung $U_T$ und die verstärkte Sensorspulenspannung $U_{S2}$ nach Passieren des Allpasses 46 auf einen Multiplizierer 55 gegeben; nach dem Passieren eines Tiefpasses 11 wird die Größe $|U_T||U_{S2}|\cos(\Phi + \theta)$ erhalten. Hier kann z.B. durch ein Multiplex-Verfahren einmal eine Phasenverschiebung $\Phi = 0$ zu $U_{S2}$ und einmal eine $\pi/2$-Phasenverschiebung erreicht werden, d.h. nach dem Tiefpaß-Filter 6 wird die Größe $|U_T||U_{S2}|\cos(\Phi + \theta)$ erhalten, wobei $\Phi$ zwischen Null und $\pi/2$ pendelt.

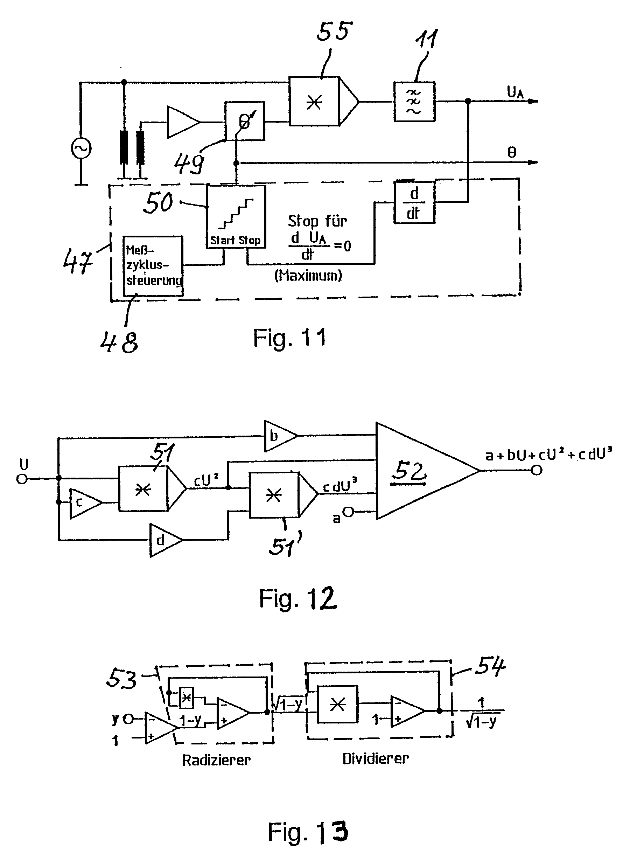

Figur 11 zeigt ein weiteres Beispiel zur Gewinnung des reellen und imaginären Anteils der Sensorspannung $U_{S2}$ mittels einer Regelschleife 47, mit der die Phasenverschiebung $\theta$ schrittweise verändert werden kann, bis die maximale Ausgangsspannung $U_A$ erreicht ist. Die Sensorspulenspannung $U_S$ passiert nach Verstärkung ein Phasendrehglied 49 und wird anschließend zusammen mit der Treiberspulenspannung $U_T$ dem Multiplizierer 55 zugeführt, dessen Ausgang auf den Tiefpaßfilter 11 gelegt ist, nach welchem die Ausgangsspannung $U_A$ erhalten wird, die in die Regelschleife 47 zurückgekoppelt ist. Eine Meßzyklussteuerung 48 steuert ein Start-Stop-Glied 50 an, welches schrittweise die Phase $\theta$ dreht und diese als Führungsgröße dem Phasendrehglied 49 zuführt. Auf diese Weise wird der Betrag und gleichzeitig die Phase der Sensorspulenspannung $U_S$ erhalten.

Figur 12 zeigt das Blockschaltbild eines Multiplizier- und Addierteils aus zwei Multiplizierern 51, 51' und einem Addierer 52 zur Erzeugung einer zum Abstand eines Prüfkörpers linearen Ausgangsspannung. Der Abstand d des Prüfkörpers von der Sensorspule kann für kleine Entfernungen durch den Polynom-Fit $d = a + bU + cU^2 + cdU^3 ....$ wiedergegeben werden. Mit den Multiplizierern 51, 51' und einem Addierer 52 kann damit eine zum Abstand d lineare Ausgangsspannung erzeugt werden.

Zur Erzeugung einer zum Abstand eines Prüfkörpers linearen Ausgangsspannung für größere Abstände, z.B. d > 10 mm, ist die Analogschaltung der Figur 13 geeignet, die aus der Hintereinanderschaltung eines Radizierers 53 und eines Dividierers 54 besteht; dies folgt aus dem Verhalten des Abstandes d gemäß
$$d = c/\{1 - U_S (d)/ U_S (\infty)\}^{1/2}$$
welches nahezu dem des erfindungsgemäßen Sensorprinzips entspricht.

Es werden somit erfindungsgemäß beim Meßvorgang induktive Kopplungen und somit Induktivitäten bzw. Gwgeninduktivitäten zwischen der Treiberspule, der Sensorspule und gegebenenfalls der oder den Referenzspulen und deren Änderungen bezüglich eines Prüfkörpers gemessen, die ein Maß über den Weg und/oder die Position im Raum und/oder von Materialeigenschaften eines elektrisch leitfähigen Prüfkörpers darstellt. Diese Meßwerte können auch auf die Leistung innerhalb des Treiberkreises bezogen bzw. umgerechnet werden, was jedoch betreffend die gewünschte Aussage über den Prüfkörper nicht notwendig ist.

In Bezugnahme auf die Figuren 1, 2 und 3 soll durch die gestrichelt gezeichnete Spule 56 angedeutet sein, daß der komplexe Referenzschaltkreis 4 zur Gewinnung der Referenzspannung eine Induktivität, vorzugsweise ein Gegeninduktivität, aufweisen kann.

Liste der Bezugszeichen:

1 Stromgenerator

2 Treiberspule

3 Sensorspule (Signalempfänger)

4 komplexer Referenzschaltkreis, z.B. eine Gegeninduktivität $Z_{ref12}$

5 Referenzspannungsleitung

6 Masseleitung der Sensorspule

7 elektrischer Baustein, u.a.wie Komparator und Dividierer

8, 8', 8" Meßverstärker

9 Dividierer

10, 10' Gleichrichter

11, 11' Tiefpassfilter

12 Frequenz-Spannungswandler

13, 14 Komparatoren bzw. Trigger bzw. Meßverstärker

15 weitere Sensorspule oder Referenzspule

16 Komparator bzw. Dividierer

17 Stromgenerator

18 Referenzspannungsleitung

19, 19' Bandfilter

20 Referenzspannungsleitung

21 Prüfkörper

22 Körper

23, 23', 23" Treiberspulen

24, 25, 26 Sensorspulen

27 magnetische Abschirmhülse, z.B. aus Ferritmaterial

. 28 Führungshülse

29 metallischer Prüfkörper in Form eines Kolbens

30 magnetische Abschirmhülse, z.B. aus Ferritmaterial

31, 32 Treiberspulen

33, 34, 35 Sensorspulen

36 metallischer Prüfkörper

37 Komparator

38 Näherungssensor

39 Sensorgehäuse (Stahl)

40 Kern

41 Treiberspule

42 Sensorspule

43 Referenzspule

44 Prüfkörper

45 Metallwand

46 Allpass

47 Regelschleife

48 Meßzyklussteuerung

49 Phasendrehglied

50 Start-Stop-Glied

51, 51' Multiplizierer

52 Addierer

53 Radizierer

54 Dividierer

55 Multiplizierer

56 Spule

$i_T$ Treiberspulenstrom

$i_S$ Sensorspulenstrom

$U_T$ Treiberspulenspannung

$U_{S1}$, $U_{S2}$, ..., $U_{Sn}$, $U_S$ Sensorspulenspannungen

$U_{Trigger}$ Schwellwertspannung oder Triggerspannung

$U_{Schalt}$ Schaltspannung

$n_0$ Windungsanzahl

$U_A$ meßseitige Ausgangsspannung oder Meßsignal

$P_T$ komplexe Leistung im Treiberspulenkreis

$P_S$ komplexe Leistung im Sensorspulenkreis

s elektrische Leitfähigkeit

µ Permeabilität

$Z_{12}$, $Z_{ref12}$ gegenseitige Induktivität zwischen Treiber- und Sensorspule bzw. zwischen Treiber- und Referenzspule

$Z_{13}$ gegenseitige Induktivität zwischen Treiberspule und sich näherndem Prüfkörper

$Z_{23}$ gegenseitige Induktivität zwischen Sensorspule und sich näherndem Prüfkörper

**Ansprüche**

1. Verfahren zum induktiven Erzeugen eines elektrischen Meßsignals zum Bestimmen des Weges und/oder der Position im Raum und/oder von Materialeigenschaften eines zu detektierenden, elektrisch leitfähigen Körpers unter Verwendung von wenigstens zwei induktiv gekoppelten Spulen, Treiberspule und Sensorspule, von denen die Treiberspule von einem höher frequenten Wechselstrom durchflossen ist, der in der Sensorspule eine von der zu messenden Größe abhängige Spannung induziert und wobei ein dem Strom in der Treiberspule proportionales Spannungssignal, Referenzspannungssignal, erzeugt wird und beide Spannungssignale zum Erhalt des Meßsignals miteinander verknüpft werden,

dadurch gekennzeichnet,

daß aus dem Referenzspannungssignal ($U_{ref}$) und dem Spannungssignal ($U_S$) der Sensorspule (3) dasjenige Meßsignal ($U_A$) gewonnen wird, bei dem durch schaltungstechnische Verknüpfung die Abhängigkeit vom Strom ($i_T$) der Treiberspule (2) aufgehoben wird und nur der vom Strom ($i_T$) unabhängige Anteil der Änderung des Betrages ($|U_S|$) und der Phase ($\Phi$) des Spannungssignals ($U_S$) der Sensorspule (3) als Parameter des Meßsignals ($U_A$) verbleiben, das proportional der induktiven Kopplung ($Z_{12}$) zwischen der Treiberspule (2) und der Sensorspule (3) ist, wobei die komplexe Leistung ($P_S$) innerhalb des Sensorkreises konstant und so nahe gegen Null wie möglich gehalten wird und das Spannungssignal ($U_S$) der Sensorspule (3) eine maximale Empfindlichkeit zum Meßgegenstand (21,36,44) hat im Gegensatz zum Referenzspannungssignal ($U_{ref}$), das eine minimale Empfindlichkeit zum Meßgegenstand besitzt.

2. Verfahren nach Anspruch 1, dadurch gekennzeichnet,

daß die mathematische Verknüpfung zur Gewinnung des Meßsignals ($U_A$) in einer Quotienten- oder Differenzbildung aus dem Referenzspannungssignal ($U_{ref}$) und dem Spannungsignal ($U_S$) der Sensorspule (3) besteht.

3. Verfahren nach Anspruch 1, dadurch gekennzeichnet,

daß die mathematische Verknüpfung zur Gewinnung des Meßsignals ($U_A$) darin besteht, daß das Referenzspannungssignal ($U_{ref}$) auf den Stromgenerator (17) für den Treiberstrom ($i_T$) rückgekoppelt wird zur Erzeugung eines konstanten Stromes ($i_T$) innerhalb der Treiberspule (2).

4. Verfahren nach Anspruch 1 oder 2 oder 3, dadurch gekennzeichnet,

daß die Ableitung des Referenzspannungssignal ($U_{ref}$) aus einem komplexen Referenzschaltkreis (4) erfolgt, der vorzugsweise eine Referenzspule (15) beinhaltet und die Gegeninduktivität ($Z_{ref12}$) zwischen der Treiberspule (2) und der Referenzspule (15) zur Gewinnung des Referenzspannungssignal ($U_{ref}$) dient.

5. Induktiver Näherungsschalter mit Messung der komplexen Leistung bzw. der magnetischen Zustände des Magnetfeldes der Treiber- und/oder Sensorspule zur Durchführung des Verfahrens nach Anspruch 1, dadurch gekennzeichnet,

daß das Spannungsignal ($U_S$) der Sensorspule (3) und das Referenzspannungssignal ($U_{ref}$) einem elektrischen Baustein (7) zugeführt und innerhalb desselben durch mathematisch-schaltungstechnische Verknüpfung der beiden Signale Betrag und Phase des Referenzspannungssignals ($U_{ref}$) eliminiert werden und somit die Abhängigkeit desselben vom Strom ($i_T$) der Treiberspule (2) aufgehoben wird und nur die vom Meßgegenstand verursachte Änderung des Betrages ($|U_S|$) und der Phase ($\Phi$) des Spannungssignals ($U_S$) als Parameter des Meßsignals ($U_A$) verbleiben, das proportional der induktiven Kopplung ($Z_{12}$) zwischen der Treiberspule (2) und der Sensorspule (3) ist, wobei die komplexe Leistung ($P_S$) inner halb des Sensorkreises konstant und so nahe gegen Null wie möglich gehalten wird und das Meßsignal ($U_A$) mit einem Fremdsignal ($U_{Trigger}$) verglichen wird zur Auslösung eines Schaltvorganges ($U_{Schalt}$).

6. Näherungsschalter nach Anspruch 5, dadurch gekennzeichnet,

daß die mathematisch-schaltungstechnische Verknüpfung des Spannungssignals ($U_S$) der Sensorspule (3) und des Referenzspannungssignals ($U_{ref}$) innerhalb des Bausteins (7) eine Quotienten- oder Differenzbildung ist.

7. Näherungsschalter nach den Ansprüchen 5 oder 6, dadurch gekennzeichnet,

daß das Referenzspannungssignal ($U_{ref}$) über einen Frequenz-Spannungswandler (12) direkt aus dem Spannungsignal ($U_T$) der Treiberspannung abgeleitet wird.

8. Näherungsschalter nach den Ansprüchen 5 oder 6, dadurch gekennzeichnet,

daß zur Gewinnung des Referenzspannungssignals ($U_{ref}$) wenigstens eine dritte Spule (Referenzspule) (15) dient, die von der Treiberspule (3) galvanisch getrennt ist und durch die induktive Kopplung die Referenzspannung ($U_{ref}$) ausbildet, wobei das Referenzspannungssignal ($U_{ref}$) der Referenzspule (15) und das Spannungsignal ($U_S$) der Sensorspule (3) in unbelastetem Zustand einem Komparator (16) zugeführt werden zur Quotienten- oder Differenzbildung.

9. Näherungsschalter nach den Ansprüchen 5 oder 8, dadurch gekennzeichnet,

daß das Spannungsignal ($U_S$) der Sensorspule (3) und das Referenzspannungssignal ($U_{ref}$) einem Dividierer (9) zugeführt werden.

10. Näherungsschalter den Ansprüchen 5 oder 8, dadurch gekennzeichnet,

daß durch Auswahl der Konfiguration von Treiber-, Sensor- und Referenzspule (2,3,15), eingebaut in ein Stahlgehäuse, eine Anordnung existiert mit hoher Empfindlichkeit senkrecht zur Stirnfläche und geringer seitlicher Empfindlichkeit, z.B. zum Einbau in eine Metallwand.

11. Positionssensor nach den Ansprüche 5 oder 8, dadurch gekennzeichnet,

daß eine Mehrzahl von Treiberspulen (31,32) und Sensorspulen (33,34,35) und/oder Referenzspulen (15) vorhanden sind, die sich in ihrer Reihenfolge jeweils abwechseln, wobei die Treiberspulen (31,32) vorzugsweise in Reihe geschaltet und jeweils dazwischen die Sensorspulen (33,34,35) bzw. die Referenzspulen (15) angeordnet sind.

12. Positionssensor für pneumatische oder hydraulische Zylinder nach Anspruch 11, dadurch gekennzeichnet,

daß wenigstens eine Treiberspule (23,23',23") und wenigstens zwei Sensorspulen (24,25,26) innerhalb eines Zylinders (22) in verschiedenen Ebenen übereinander ringförmig angeordnet sind, wobei die Windungszahlen der Sensorspulen unterschiedlich sind und der Zylinder zur magnetischen Abschirmung mit magnetisch leitendem Material ummantelt ist.

13. Näherungsschalter nach den Ansprüchen 5 oder 8, dadurch gekennzeichnet,

daß derselbe ein Phasendrehglied (49) aufweist, welches Teil einer Regelschleife (47) ist, die in zyklischer Weise anwachsend eine veränderbare Führungsgröße für die Phase liefert.

Fig. 1

Fig. 2

Fig. 3

Fig. 4

Fig. 5

Fig. 8

Fig. 6

Fig. 7

Fig. 9

Fig. 10

Fig. 11

Fig. 12

Fig. 13